# EUROPEAN PATENT SPECIFICATION

(11) **EP 0 517 042 B1**
(45) Date of publication and mention of the grant of the patent: **18.10.1995**
(21) Application number: 92108622.9
(22) Date of filing: 21.05.1992
(51) Int. Cl.: C23C 16/48

(54) **Plasma-chemical vapor-phase epitaxy system**
Beschichtungssystem zur plasmachemischen Gasphasenabscheidung
Système d'épitaxie chimique en phase vapeur utilisant du plasma

(30) Priority: 05.06.1991 JP 134259/91
(43) Date of publication of application: 09.12.1992
(73) Proprietor: MITSUBISHI JUKOGYO KABUSHIKI KAISHA, Tokyo (JP)
(72) Inventor: Hamamoto, Kazutoshi, c/o Nagasaki Shipyard & Mach., Nagasaki-shi, Nagasaki-ken (JP); Uchida, Satoshi, c/o Nagasaki Shipyard & Mach., Nagasaki-shi, Nagasaki-ken (JP); Murata, Masayoshi, c/o Nagasaki Res. & Dev. Cent., 5-chome, Nagasaki-shi, Nagasaki-ken (JP); Takeuchi, Yoshiaki, c/o Nagasaki Res. & Dev. Cent., 5-chome, Nagasaki-shi, Nagasaki-ken (JP); Kodama, Masaru, c/o Nagasaki Res. & Dev. Cent., 5-chome, Nagasaki-shi, Nagasaki-ken (JP)
(74) Representative: Henkel, Feiler, Hänzel & Partner

(56) References cited:
- DE-A- 3 011 686
- US-A- 4 729 341

## Description

### BACKGROUND OF THE INVENTION:

### Field of the Invention:

The present invention relates to a plasma-chemical vapor-phase epitaxy system, i.e., a chemical vapor deposition system (hereinafter abbreviated as CVD system) which is suitable for manufacture of a thin film for use in various electronic devices such as amorphous silicon solar cells, thin film semiconductors, photo-sensors, semiconductor protective films, etc.

### Description of the Prior Art:

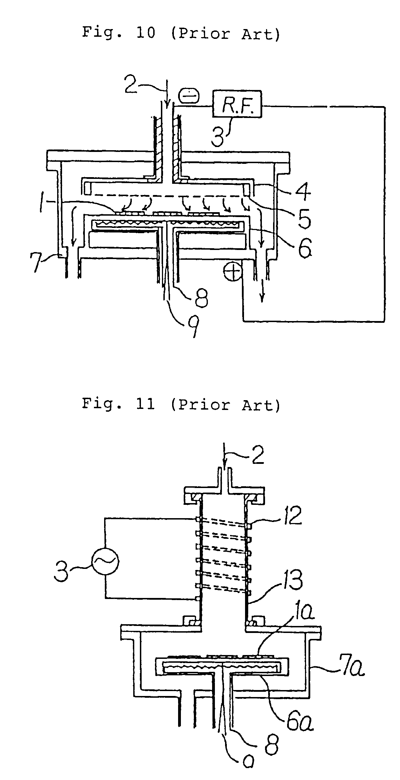

One example of a parallel plate type plasma CVD system in the prior art is illustrated in Fig. 10. In this system, substrates 1 are disposed as opposed to a plate type RF (Radio-Frequency) electrode 5 equipped within a vacuum container 7.

Reaction gas 2 is made to pass through the RF electrode 5, and when an RF voltage is applied from an RF power supply to the RF electrode 5, plasma is produced. Owing to this plasma, a reaction occurs and a thin film is formed on the substrates 1 as a result of CVD. In this figure, reference numeral 4 designates a shield, numeral 6 designates a substrate holder, numeral 8 designates a heater for heating substrates, and numeral 9 designates a thermo-couple for detecting a temperature.

Also, one example of an RF induction coupling type plasma CVD system in the prior art is shown in Fig. 11. In this system, a quartz discharge tube 13 is mounted above a vacuum container 7a coaxially with the container, and around the discharge tube 13 is wound a discharging coil 12. In addition, substrates 1a are disposed at the center of the vacuum container 7a.

Reaction gas 2 is introduced from the above of the quartz discharge tube 13, and when electric power is applied from an RF power supply 3 to the discharging coil 12, plasma is produced within the discharging tube 13. Thereby, a thin film is formed on the substrates 1a as a result of CVD.

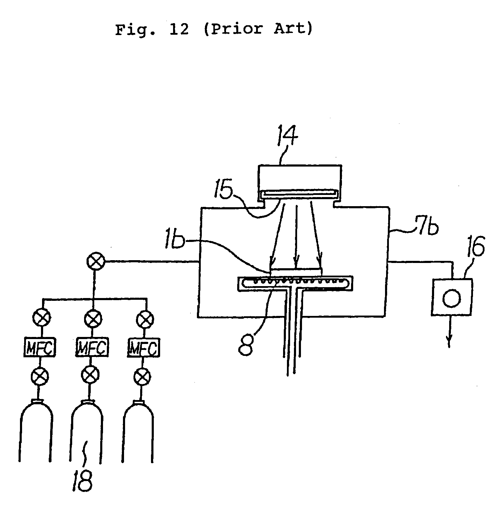

One example of a photo-CVD system in the prior art is illustrated in Fig. 12. A substrate 1b is disposed nearly at the center of a vacuum container 7b, and a light source 14 is disposed above the substrate 1b via a quartz glass window 15.

Reaction gas introduced into the vacuum container 7b is made to react by energy of light radiated from the light source 14, and thereby a thin film is formed on the substrate 1b as a result of CVD.

A characteristic property of the above-mentioned RF parallel plate type plasma CVD system in the prior art is that formation of a film having a large area of about 70 cm square is possible, and this system belongs to a most orthodox type of systems. However, due to the fact that the electrode is placed within the vacuum container, this system involves the problems such as mixing of impurities released from the electrode and production of particles caused by peeling of films. In the case of the RF induction-coupling type plasma CVD system, although mixing of impurities of an electrode would not occur because of the fact that a discharging coil is disposed outside of a vacuum container, it is difficult to modify so as to deal with a large area, hence it is not suitable as a system for mass-production, and it is solely used for the purpose of research. Though the photo-CVD system is not provided with an electrode and hence it can produce a film of very high quality, it involves the problem that as a film is deposited on a glass window, light cannot pass through the window and formation of a film becomes impossible.

Summarizing the above-described problems involved in the heretofore known CVD systems, they can be enumerated as follows:
(1) In the case where an electrode for performing RF discharge is present in vacuum, generation of impurities from the electrode and peeling of films would adversely affect a film on a substrate.
(2) In a system of introducing excitation energy from the outside by making use of a coil in place of an RF discharging electrode, it is difficult to adapt the system for large-area film formation.
(3) In a photo-CVD system, although a film of high quality can be formed, formation of a film would become impossible due to change of a glass plate into an opaque state.

From DE-A-3 011 686 there is known a plasma treating device using microwave energy, in which the electromagnetic waves for producing the plasma are directed radially from a tubular antenna through a cylindrical body made from quartz. Substrates are provided on the interior circumferential wall of another quartz cylinder. Thus, since in this device only a cylindrical plasma can be formed around the antenna, in cases where the substrates are planar and have a larger size, there are not only problems with respect to accomodating the substrates within the cylinder but also the film produced on the substrates will not be uniform because the cylindrical plasma generated by the electric field of a not uniform field intensity distribution is not uniform along its diameter.

### SUMMARY OF THE INVENTION:

It is therefore one object of the present invention to provide an improved plasma CVD system, which can avoid mixing of particles and impurities into a formed thin film, and which makes it possible to form a thin film on a large area substrate.

According to the present invention, there is provided a plasma-chemical vapor-phase epitaxy system, comprising a vacuum container having a planar window made of dielectrics, means for holding a substrate to be disposed within the vacuum container as opposed to the window, planar antenna type discharge means disposed outside of the vacuum container as opposed to the window, and a high-frequency power supply for feeding electric power to the antenna type discharge means.

According to another preferred embodiment of the present invention, there is provided the above-featured plasma-chemical vapor-phase epitaxy system, which further comprises a coil disposed so as to surround the vacuum container with its axis intersected at right angles with the axis of the antenna type discharge means, and an A.C. power supply for feeding electric power to the coil.

According to the present invention, owing to the structural feature, when reaction gas is introduced into the vacuum container and electric power is fed to the planar antenna type discharge means, an electromagnetic wave is radiated from the antenna type discharge means towards the substrate. Due to this electromagnetic wave, plasma of uniform density in parallel with the substrate is produced within the vacuum container, thereby the reaction gas reacts, and a thin film is formed on the substrate as a result of CVD.

In this way, a thin film can be formed on a large-sized substrate, and owing to non-existence of an electrode within a vacuum container, mixing of impurities from an electrode into a formed film nor peeling of a film would not occur.

Also, according to the present invention, owing to the structural feature of the above embodiment, when an electric current is fed from the A.C. power supply to the coil, an A.C. magnetic field is generated in the axial direction of the coil. Since this magnetic field is generated in the direction intersecting at right angles to the electric field of the electromagnetic wave, the plasma produced by the electromagnetic wave is made to swing, and so, a more uniform thin film is formed on the substrate.

The above-mentioned and other objects, features and advantages of the present invention will become more apparent by reference to the following description of a number of preferred embodiment of the invention taken in conjunction with the accompanying drawings.

### BRIEF DESCRIPTION OF THE DRAWINGS:

In the accompanying drawings:
Fig. 1 is a cross-section view of a general construction according to a first preferred embodiment of the present invention;
Fig. 2 is a perspective view showing details of an antenna type discharging electrode portion in the same preferred embodiment;
Fig. 3 is a circuit diagram of an electrode and an RF tuning circuit in the same preferred embodiment;
Fig. 4 is a three-dimensional diagram to be referred to for explaining operations of the same preferred embodiment;
Fig. 5 is a schematic view showing examples of an electrode in the same preferred embodiment;
Fig. 6 is a cross-section view of a construction according to a second preferred embodiment of the present invention;
Fig. 7 is a cross-section view of a construction according to a third preferred embodiment of the present invention;
Fig. 8 is a cross-section view of a construction according to a fourth preferred embodiment of the present invention;
Fig. 9 is a cross-section view of a construction according to a fifth preferred embodiment of the present invention;
Fig. 10 is a cross-section view of a parallel plate type system in the prior art;
Fig. 11 is a cross-section view of an induction coupling type system in the prior art; and
Fig. 12 is a cross-section view of an optical type system in the prior art.

### DESCRIPTION OF THE PREFERRED EMBODIMENTS:

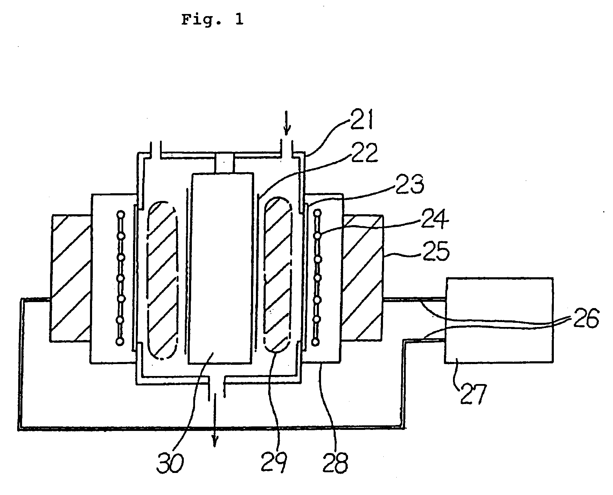

Now, a first preferred embodiment of the present invention will be explained with reference to Figs. 1 through 5. It is to be noted that the portion already described in connection with the systems in the prior art will be omitted from the explanation and the portion relevant to this invention will be mainly described.

In Fig. 1, a vacuum container 21 has quartz glass windows 23 on its opposite side surfaces. In addition, at a central portion of the vacuum container 21 is provided a heater 30 for heating substrates, which has planes in parallel to the windows 23 on its opposite side surfaces. Furthermore, on the opposite side surfaces of the heater 30 are disposed substrates 22 which are nearly as large as the windows 23.

Also, in the proximity of the outsides of the windows 23 are provided antenna type discharging electrodes 24 with their axes held nearly vertically, and they are respectively covered by high-frequency shield boxes 28 made of aluminium. Furthermore, the antenna type discharging electrodes 24 are respectively connected to a radio-frequency (RF) power supply 27 via radio-frequency (RF) tuning circuits 25.

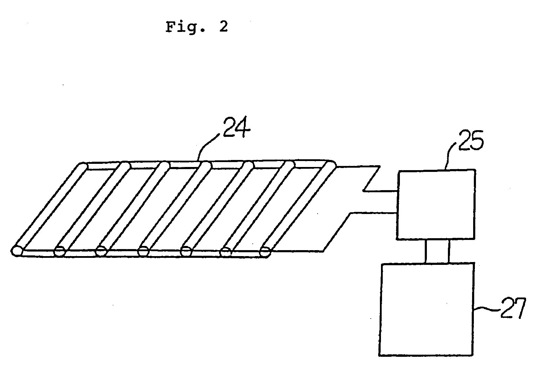

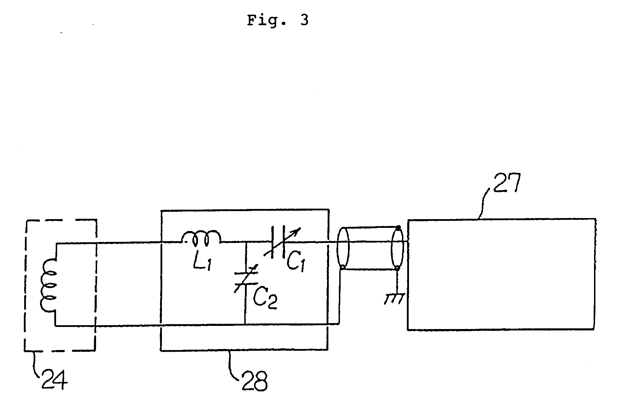

In the antenna type discharging electrode 24, as shown in detail in Fig. 2, conductor elements are disposed in a ladder shape having an external size nearly equal to the windows 23, and RF power is fed to the elements on the opposite sides via the RF tuning circuit 25. In addition, an electric circuit diagram of this portion is shown in Fig. 3.

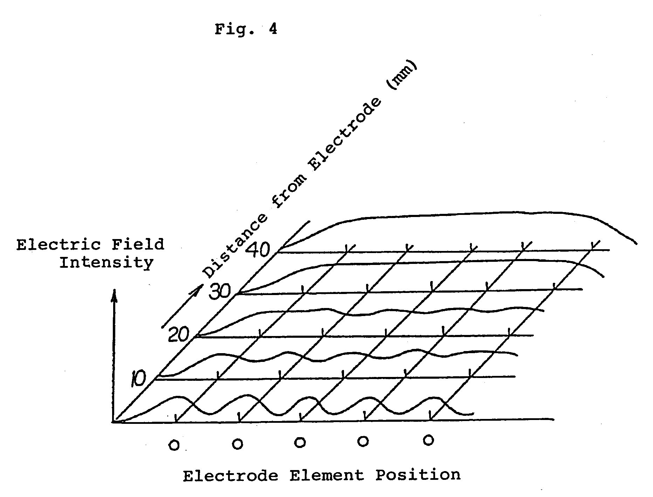

In the above-described embodiment, when a thin film of amorphous silicon is to be formed, for instance, on a film forming substrate 22 (a wafer of glass, silicon or the like), SiH₄ gas is supplied into the vacuum container 21. The pressure in the vacuum container 21 is maintained at about 13.3-133 Pa (0.1 - 1 Torr), and the substrate 22 is heated by the heater 30 up to a predetermined temperature. Then, RF power is fed from an RF power supply 27 of 13.56 MHz to the antenna type discharging electrode 24 via the RF tuning circuit 25. Then an electromagnetic wave having an electric field distribution, which becomes a uniform distribution as the position shifts from the electrode 24 towards the substrate 22 as shown in Fig. 4, is generated. More particularly, while the electric field has an uneven distribution radiated coaxially from the centers of the electrode elements in the vicinity of the electrode 24, the electric field distribution would become flat as the Position shifts farther from the centers of the electrode elements towards the substrate 22 by 20 mm, 40 mm and so on. Owing to this electric field having a flat distribution, uniform plasma 29 is produced within the container 21. Reaction gas would react due to this plasma 29, and a uniform thin film of amorphous silicon is formed on the substrate 22 as a result of CVD.

In this system, the RF shield boxes 28 serve to feed electromagnetic waves radiated from the electrodes 24 into the container 21 and to prevent them from leaking out to the external space. Also, the RF tuning circuits 25 serve to efficiently feed the electric power generated by the RF power supply 27 to the electrodes 24. In this way, a thin film can be formed on the large-sized substrates 22, and moreover, owing to the fact that an electrode is not present within the vacuum container 21, mixing of impurities released from the electrodes nor peeling of a film does not occur. Also, since electromagnetic waves are utilized, there is provided a CVD system which is not influenced even if the quartz glass windows were to become opaque.

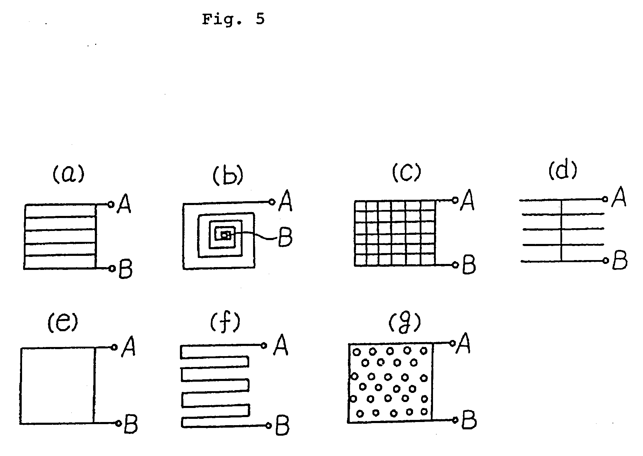

It is to be noted that as the antenna type discharging electrode 24, beside the above-described type of electrode, an electrode of ladder type, spiral type, net type, ribs type, flat plate type, zig-zag type, punched plate type, etc. as shown in Figs. 5(a) through 5(g) could be employed.

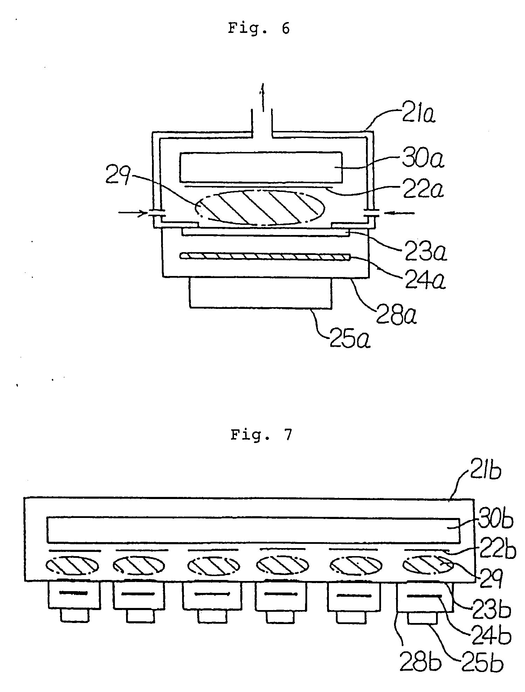

Next, a second preferred embodiment of the present invention will be described with reference to Fig. 6.

This embodiment is constructed by taking out only a left-half or a right-half of the first preferred embodiment and arranging it in a horizontal type. That is, a quartz glass window 23a is disposed on a bottom surface of a vacuum container 21a. In this figure, reference numeral 22a designates a substrate, numeral 24a designates an antenna type electrode, numeral 25a designates an RF tuning circuit, and numeral 28a designates an RF shield box.

Since operations and advantages of this embodiment are almost similar to those of the first preferred embodiment, further explanation thereof will be omitted.

Now a third preferred embodiment of the present invention will be described with reference to Fig. 7.

This embodiment is constructed by providing the system of the second preferred embodiment in multiple and integrating them in a large size. In this figure, reference numeral 21b designates a vacuum container, numeral 30b designates a heater, numeral 22b designates a plurality of substrates, numeral 23b designates a plurality of quartz glass windows provided on the bottom surface of the vacuum container 21b, numeral 24b designates antenna type discharging electrodes provided at the respective window portions, numeral 28b designates RF shield boxes surrounding the respective discharging electrodes, and numeral 25b designates RF tuning circuits for the respective discharging electrodes. The operations and advantages of the each portion in this preferred embodiment are almost similar to those of the second preferred embodiment. In this way, it becomes possible to form films simultaneously on a plurality of substrates 22b.

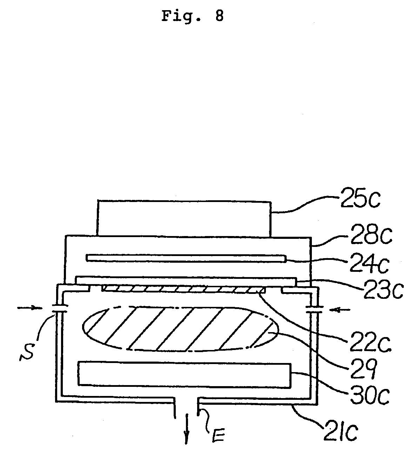

A fourth preferred embodiment of the present invention will be described with reference to Fig. 8. In this embodiment, a quartz glass window 23c is provided on a top surface of a vacuum container 21c. A substrate 22c is disposed on an inner surface of the window 23c. Furthermore, an infrared ray heater 30c is provided under the substrate 22c as opposed thereto to heat a film-forming surface of the substrate 22c. It is to be noted that reaction gas supply ports S are provided at upper portions of the container 21c and an exhaust port E is provided on the bottom surface so that dust may not attach onto the substrate 22c. The other operations and advantages of this embodiment are similar to those of the second preferred embodiment.

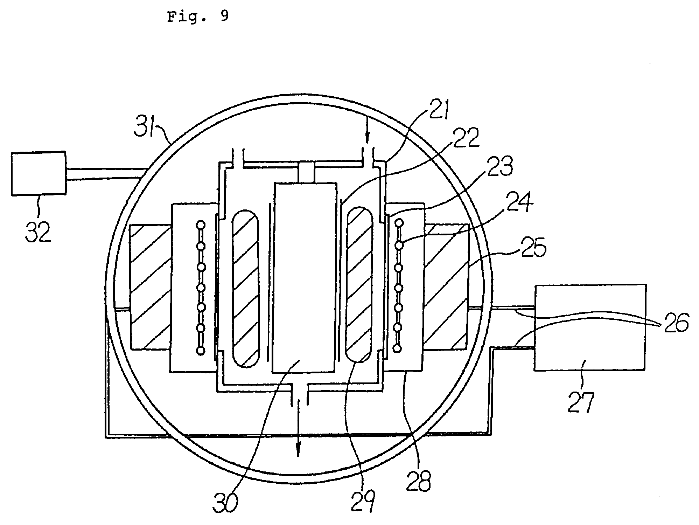

Now a fifth preferred embodiment of the present invention will be described with reference to Fig. 9. In this preferred embodiment, the vacuum container portion 21 of the first preferred embodiment is disposed in a coil 31 connected to an A.C. power supply 32 and having its axis directed horizontally.

In the above-described construction, in addition to the operation similar to the first preferred embodiment, the coil 31 generates an A.C. magnetic field which intersects perpendicularly to the electric fields of the electromagnetic waves generated by the electrodes 24. Accordingly, particles of the plasma 29 produced within the container 21 are made to swing, hence formation of a film by CVD on the substrates 22 is promoted, and the formed film becomes more uniform.

As will be apparent from the detailed description of the preferred embodiments above, according to the present invention, since an electrode is not equipped within a vacuum container, mixing of particles peeled off from a formed film nor impurities released from an electrode does not occur, and in addition owing to the planar antenna type discharging electrodes, formation of a large-sized uniform thin film would become possible. Accordingly, the subject CVD system is extremely effective for use as a manufacturing system of amorphous silicon solar cells, thin film semiconductors, photo-sensors, semiconductor protective films, etc.

## Claims

1. A plasma-chemical vapor-phase epitaxy system, comprising a vacuum container (21, 21a, 21b, 21c) having a planar window made of dielectrics (23, 23a, 23b, 23c), means for holding a substrate (22, 22a, 22b, 22c) to be disposed within said vacuum container as opposed to said window, planar antenna type discharge means (24, 24a, 24b, 24c) disposed outside of said vacuum container as opposed to said window, and a high-frequency power supply (27) for feeding electric power to said antenna type discharge means.

2. A plasma-chemical vapor-phase epitaxy system as claimed in claim 1, wherein a heater (30, 30a, 30b, 30c) for heating a substrate is disposed within the vacuum container.

3. A plasma-chemical vapor-phase epitaxy system as claimed in claim 1 or 2, wherein there is provided high-frequency shield means (28, 28a, 28b, 28c) covering said antenna type discharge means.

4. A plasma-chemical vapor-phase epitaxy system as claimed in any one of claims 1 to 3, further comprising a coil (31) disposed so as to surround said vacuum container with its axis intersected at right angles with the axis of said antenna type discharge means (24), and an A.C. power supply (32) for feeding electric power to said coil.

5. A plasma-chemical vapor-phase epitaxy system as claimed in any one of the preceding claims, wherein a substrate (22, 22a, 22b, 22c) is disposed within said vacuum container (21, 21a, 21b, 21c).

## Patentansprüche

1. Plasmachemisches Gasphasen-Epitaxiesystem, mit
einem Vakuumbehälter (21, 21a, 21b, 21c) mit einem planaren Fenster aus einem Nichtleiter (23, 23a, 23b, 23c),
einer Einrichtung zum Halten eines im Vakuumbehälter gegenüber dem Fenster anzuordnenden Substrats (22, 22a, 22b, 22c),
einer außerhalb des Vakuumbehälters gegenüber dem Fenster angeordneten planaren antennenartigen Entladungseinrichtung (24, 24a, 24b, 24c) und
einer Hochfrequenz-Energieversorgung (27) zum Zuführen von elektrischer Energie zu der antennenartigen Entladungseinrichtung.

2. Plasmachemisches Gasphasen-Epitaxiesystem gemäß Anspruch 1, bei dem eine Heizeinrichtung (30, 30a, 30b, 30c) zum Erwärmen eines Substrats im Vakuumbehälter angeordnet ist.

3. Plasmachemisches Gasphasen-Epitaxiesystem gemäß Anspruch 1 oder 2, bei dem eine die antennenartige Entladungseinrichtung abdeckende Hochfrequenz-Abschirmungseinrichtung (28, 28a, 28b, 28c) vorgesehen ist.

4. Plasmachemisches Gasphasen-Epitaxiesystem gemäß einem der Ansprüche 1 bis 3, mit einer Spule (31), die so angeordnet ist, daß sie den Vakuumbehälter umgibt und ihre Achse sich unter einem rechten Winkel mit der Achse der antennenartigen Entladungseinrichtung (24) schneidet, und mit einer Wechselspannungs-Energieversorgung (32) zum Zuführen von elektrischer Energie zu der Spule.

5. Plasmachemisches Gasphasen-Epitaxiesystem gemäß einem der vorstehenden Ansprüche, bei dem ein Substrat (22, 22a, 22b, 22c) im Vakuumbehälter (21, 21a, 21b, 21c) angeordnet ist.

## Revendications

1. Système d'épitaxie chimique en phase vapeur utilisant un plasma comprenant un récipient à vide (21, 21a, 21b, 21c) comportant une fenêtre (23, 23a, 23b, 23c) plane formée d'une matière diélectrique, un moyen pour supporter un substrat (22, 22a, 22b, 22c) devant être disposé à l'intérieur dudit récipient à vide en face de ladite fenêtre, un moyen de décharge (24, 24a, 24b, 24c) du type antenne, et un source d'alimentation (27) haute fréquence pour alimenter en énergie électrique ledit moyen de décharge du type antenne.

2. Système d'épitaxie chimique en phase vapeur utilisant un plasma selon la revendication 1, dans lequel un dispositif de chauffage (30, 30a, 30b, 30c) destiné à chauffer un substrat est disposé à l'intérieur du récipient à vide.

3. Système d'épitaxie chimique en phase vapeur utilisant un plasma selon la revendication 1 ou 2, dans lequel un moyen (28, 28a, 28b, 28c) formant écran vis-à-vis des haute-fréquences recouvre ledit moyen de décharge du type antenne.

4. Système d'épitaxie chimique en phase vapeur utilisant un plasma selon l'une quelconque des revendications 1 à 3, comprenant, en outre, une bobine (31) disposée de manière à entourer ledit récipient à vide avec son axe intersecté à angle droit par l'axe dudit moyen (24) de décharge du type antenne, et une source (32) de courant alternatif pour alimenter en énergie électrique ladite bobine.

5. Système d'épitaxie chimique en phase vapeur utilisant un plasma selon l'une quelconque des revendications précédentes, dans lequel un substrat (22, 22a, 22b, 22c) est disposé à l'intérieur du récipient à vide (21, 21a, 21b, 21c).
